(19) Europäisches Patentamt
European Patent Office
Office européen des brevets

(11) **EP 4 207 255 A1**

## (12) EUROPEAN PATENT APPLICATION
published in accordance with Art. 153(4) EPC

(43) Date of publication:
**05.07.2023 Bulletin 2023/27**

(21) Application number: **21861558.1**

(22) Date of filing: **24.08.2021**

(51) International Patent Classification (IPC):
**H01L 21/60** (2006.01)

(52) Cooperative Patent Classification (CPC):
**H01L 24/45; H01L 21/60;** H01L 2224/45124

(86) International application number:
**PCT/JP2021/030993**

(87) International publication number:
**WO 2022/045133 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.08.2020 JP 2020145644**

(71) Applicants:
• **Nippon Micrometal Corporation**
**Iruma-shi**
**Saitama 358-0032 (JP)**
• **NIPPON STEEL Chemical & Material Co., Ltd.**
**Tokyo 103-0027 (JP)**

(72) Inventors:
• **UNO, Tomohiro**
**Tokyo 100-8071 (JP)**
• **OYAMADA, Tetsuya**
**Tokyo 100-8071 (JP)**
• **ODA, Daizo**
**Iruma-shi, Saitama 358-0032 (JP)**
• **KURIHARA, Yuto**
**Iruma-shi, Saitama 358-0032 (JP)**
• **OISHI, Ryo**
**Iruma-shi, Saitama 358-0032 (JP)**

(74) Representative: **Vossius & Partner**
**Patentanwälte Rechtsanwälte mbB**
**Siebertstraße 3**
**81675 München (DE)**

## (54) AL WIRING MATERIAL

(57) There is provided a novel Al wiring material that suppresses an increase in cold strength and exhibits a favorable high-temperature reliability. The Al wiring material contains one or more selected from the group consisting of Er, Yb and Gd so as to satisfy $0.001 \leq x1 \leq 0.6$ where x1 is a total content thereof [% by mass], with the balance comprising Al.

**Description**

**TECHNICAL FIELD**

The present invention relates to an Al wiring material. The present invention further relates to a semiconductor device including the Al wiring material.

**BACKGROUND ART**

As for a linear material used for electrical connection and/or mechanical connection in industrial devices and electronic parts, the use of aluminum (Al) is increasing with a demand of computerization of automobiles since aluminum is more lightweight and inexpensive than copper (Cu) which has been conventionally used. For an Al wire (circle) and an Al strip (flat or ellipse) used for industrial devices such as a conveying device and a robot, there are required mechanical properties such as a breaking strength and an elongation, an electrical conductivity, a thermal conductivity, and the like depending on the purposes of use.

In a semiconductor device, electrodes formed on a semiconductor element are connected with a lead frame or electrodes on a circuit board (hereinafter also referred to as "substrate") using a bonding wire or a bonding ribbon. In a power semiconductor device, Al is mainly used for the bonding wire or bonding ribbon. For example, Patent Literature 1 discloses an example of using an Al bonding wire with a diameter of 300 um in a power semiconductor module. In the power semiconductor device using the Al bonding wire or Al bonding ribbon, wedge bonding is used as a bonding process for both of first connection with electrodes on a semiconductor chip and second connection with the lead frame or electrodes on a substrate.

Hereinafter, the above-described Al wire, Al strip, Al bonding wire, Al bonding ribbon, and the like are collectively referred to as an Al wiring material.

Power semiconductor devices using Al wiring materials are often used as semiconductor devices for large power equipment such as air conditioners and photovoltaic power generation systems, and on-vehicle semiconductor devices. In these semiconductor devices, the connected part between the wiring material and a member to be connected is exposed to a high temperature of 120°C or more during operation of the devices. Further, when the semiconductor devices operate by switching high voltage on and off at high speed, it is exposed a severe environment where the temperature is repetitively increased and decreased. When using a material composed only of high purity Al as the wiring material, softening of the wiring material tends to proceed in such a temperature environment at the time when the device operates, and it is difficult to use such wiring material in a high temperature environment.

There has been developed an Al wiring material made of a material obtained by adding a specific element to Al. For example, Patent Literature 2 discloses an Al bonding wire the mechanical strength of which is improved by adding scandium (Sc) of 0.05 to 1 % by weight to Al to be precipitation-hardened. Patent Literature 3 discloses an Al bonding wire in which 0.15 to 0.5% by mass of Sc is added to Al and forcibly caused to be solid solution, where the wire is precipitation-hardened by an aging heat treatment after connection. Patent Literature 4 discloses that an Al wiring material containing one or more of nickel (Ni), silicon (Si), and phosphorus (P), the amount of which is 800 ppm by mass or less in total, has favorable bonding strength and weather resistance. Patent Literature 5 discloses an Al bonding wire containing 0.01 to 0.2 % by mass of iron (Fe) and 1 to 20 ppm by mass of Si in which a solid solution amount of Fe is 0.01 to 0.06 % by mass, a precipitation amount of Fe is seven times or less the solid solution amount, and an average crystal grain diameter is 6 to 12 $\mu$m, and describes that this wire has favorable bonding reliability.

**RELATED ART REFERENCE**

**Patent Literature**

Patent Literature 1: JP-A-2002-314038
Patent Literature 2: JP-A-2016-511529
Patent Literature 3: JP-A-2014-47417
Patent Literature 4: JP-A-2016-152316
Patent Literature 5: JP-A-2014-129578

## SUMMARY OF INVENTION

## PROBLEM TO BE SOLVED BY THE INVENTION

With enhancement of functions of industrial devices and electronic parts and with expansion of application thereof, a requirement for Al wiring materials used therefor becomes higher. For an Al wiring material used for industrial devices such as a conveying device and a robot, it is required an adaptability to a high-temperature environment or repetitive bending deformation. Recently, during use in a high-temperature environment in automotive applications, the strength of the wire deteriorates to cause an inferior deformation or cracks which may lead to disconnection. Therefore, it is required to suppress a decrease in strength of the Al wiring material in a high-temperature environment to improve a high-temperature reliability. However, when the strength of the wiring material is merely increased, it is difficult to achieve a sufficient high-temperature reliability, and also, there are concerns that the wiring material deteriorates in workability, bondability, and the like during installation and use thereof.

For an Al wiring material used for electronic parts such as a semiconductor, owing to expansion of application of automotive power devices, it is required to improve the initial bondability and the high-temperature reliability of the connection part. In a semiconductor, the Al wiring material is used for two connections including the connection with electrodes on a semiconductor chip (hereinafter referred to as "first connection") and the connection with the lead frame or external electrodes on a substrate (hereinafter referred to as "second connection"). In power devices, an impulsive thermal stress may be caused in accordance with a temperature change during operation of the devices (hereinafter referred to as "thermal shock"), and the first connection part which is the connection part between the Al wiring material and the electrode on the semiconductor chip may be damaged. Specifically, due to a difference between coefficients of thermal expansion of the Al wiring material and the member to be connected, a crack may be caused at an interface of the connection part (hereinafter referred to as "bond crack"). Also, due to a bending stress caused by expansion and contraction of the Al wiring material itself, a crack may be caused at a loop rising part in the vicinity of the connection part (hereinafter referred to as "heel crack"). The bond crack or the heel crack develops with corrosion in an environment at the time when the device operates, and the Al wiring material finally comes off from the member to be connected. Thus, the high-temperature reliability of the connection part is deteriorated. In this regard, there is a method of adding other element(s) to the Al wiring material to suppress the coarsening of crystal grains, and increasing the strength of the Al wiring material. However, in such a method, as the content of these elements in the Al wiring material increases, a yield may be lowered because the wire breakage or damage occurs at the time of manufacturing the Al wiring material, or a member to be connected may be damaged at the time of connecting the Al wiring material to the member to be connected (hereinafter referred to as "chip damage").

Therefore, the Al wiring material is required to improve the high-temperature reliability, as well as to suppress an increase in cold strength to maintain and improve the workability at the time of deformation and bonding.

Further, it is known that an addition of Sc to the Al wiring material improves the high-temperature reliability (Patent Literatures 2 and 3). However, even in the technique, it is affected by an increase in cold strength. In addition, the material cost becomes high since Sc is expensive, and conditions of a heat treatment during the production of the Al wiring material or an additional heat treatment after the connection thereof are need to be controlled within a limited range in order to improve the high-temperature reliability using a precipitation of Sc. These prevents practical utilization.

With regard to the heat treatment during the production of the wiring material or the additional heat treatment after the connection of the wiring material, if improved performances can be achieved by a low-temperature or short-time treatment, the productivity of the wiring material can be improved, and a thermal influence on the member to be connected and the like can be decreased.

Thus, many required performances can be comprehensively satisfied.

An object of the present invention is to provide a novel Al wiring material that suppresses an increase in cold strength and exhibits a favorable high-temperature reliability.

## MEANS FOR SOLVING PROBLEM

As a result of earnest investigation as to the problem described above, the present inventors have found that the problem described above can be solved by the Al wiring material having the configuration described below, and further investigated the problem based on such knowledge to complete the present invention.

Specifically, the present invention includes the following.

[1] An Al wiring material containing one or more selected from the group consisting of Er, Yb and Gd so as to satisfy

$$0.001 \leq x1 \leq 0.6$$

where x1 is a total content thereof [% by mass],
with the balance comprising Al.

[2] The Al wiring material according to [1], further containing one or more selected from the group consisting of Sc and Zr so as to satisfy

$$0.005 \leq x2 \leq 0.6$$

where x2 is a total content thereof [% by mass].

[3] The Al wiring material according to [1] or [2], further containing one or more selected from the group consisting of Si, Fe, Ni, Ce, Y and Zn so as to satisfy

$$0.001 \leq x3 \leq 1$$

where x3 is a total content thereof [% by mass].

[4] The Al wiring material according to any one of [1] to [3], wherein the Al wiring material is a bonding wire.

[5] A semiconductor device comprising the Al wiring material according to any one of [1] to [4].

**EFFECT OF THE INVENTION**

The present invention can provide a novel Al wiring material that suppresses an increase in cold strength and exhibits a favorable high-temperature reliability. The novel Al wiring material can suppress an increase in cold strength and enhance the workability during installation and connection to a device, and the productivity. The novel Al wiring material can also maintain and improve the strength during use in a high-temperature environment and exhibit a favorable high-temperature reliability by performing a low-temperature or short-time treatment for the heat treatment during the production of the wiring material or the additional heat treatment after the connection or without requiring the heat treatment.

**EMBODIMENT FOR CARRYING OUT THE INVENTION**

Hereinafter, the present invention will be described in detail with reference to preferable embodiments thereof.

[Al wiring material]

The Al wiring material of the present invention contains one or more selected from the group consisting of Er, Yb and Gd so as to satisfy $0.001 \leq x1 \leq 0.6$ where x1 is a total content thereof [% by mass].
By adding a small amount of one or more selected from the group consisting of Er, Yb and Gd (hereinafter also referred to as "first group element") into the Al wiring material, it is possible to enhance the high-temperature reliability of the Al wiring material. Moreover, it is possible to suppress an increase in the cold strength of the Al wiring material and to improve the workability of deformation and bonding. Such high-temperature reliability can be confirmed on the basis of the fact that the strength of the Al wiring material after a high-temperature heating can be maintained or increased compared to that before the high-temperature heating. Further, such cold strength can be confirmed on the basis of the facts that an increase in the hardness of the Al wiring material is suppressed, a damage to the member to be connected at the time of connecting (such as a semiconductor chip) is suppressed, and the initial bondability is favorable.
There will be described an example of the properties evaluated for the Al wiring material in which the first group element is added. For such Al wiring material, the rupture strength can be increased when heated at a high temperature of 300 to 500°C for a long time. Specific example of the effect that such Al wiring material can achieve during use in a severe high-temperature is as follows. Even after being heated at 350°C for 4 hours, deterioration of the rupture strength of the Al wiring material can be suppressed, and rather the rupture strength can be increased.
The present inventors have found that in a case where an Al alloy containing the first group element is processed to a wiring material, the effect of improving the high-temperature reliability that is achieved by the addition of these elements is higher than the improvement effect obtained for the member such as bulks and plates. It is considered that the precipitation of Er, Yb and/or Gd in the Al alloy and the state of the solid solution favorably affect the high-temperature reliability by utilizing the formation of texture in the wire-drawing, the progress of recrystallization by the thermal treatment of heating and cooling in the thin wire, and the like.

The characteristics of Er, Yb and/or Gd include a high diffusion speed of atoms in Al and a low maximum concentration (maximum solid solubility) that can be dissolved in Al, and it is considered that the precipitation is accelerated during heating to favorably improve the high-temperature reliability. Specifically, with regard to the addition of Er, Yb and/or Gd, it is considered that the strength can be improved even in a low-temperature and short-time heat treatment because the nuclei of the precipitate can be efficiently formed even when adding these elements in a small amount and the precipitation rate is high.

By heating the Al alloy that contains the first group element, it is possible to form a stable precipitate such as $Al_3Er$, $Al_3Yb$ and/or $Al_3Gd$ which are/is an intermetallic compound between the first group element and Al. Since these precipitates have good compatibility with Al at the interface of the precipitates, it is considered that dislocations and migration of grain boundaries are suppressed, and these precipitates are highly effective in increasing a strength, a hardness, a ductility, and the like in a high-temperature environment.

By adding the first group element, the efficiency of precipitate formation is increased, and thus, it is easy to control the size, density, and the like of the precipitate. As a result, compared to Sc addition and the like which have been conventionally performed, the strength of the material can be improved even when treated by a low-temperature and short-time heat treatment, and the addition effect of increasing the strength in a high-temperature environment is dominantly higher. These matters can greatly contribute to the improvement of the high-temperature strength. It is also a practical advantage that such a remarkable function can be realized by a relatively inexpensive material.

The first group element, i.e., Er, Yb and/or Gd can similarly exhibit the addition effect described above. Furthermore, the characteristics of each element can be utilized to achieve optimization according to requirements. For example, with regard to Er, the Al-Er system is eutectic, and it is relatively easy to maintain the supersaturated solid solution state required for precipitation. It is also possible to promote high strength by utilizing the solid solution strengthening. Among the first group elements, only Yb has the face-centered cubic structure and the diffusion speed thereof in Al is also the fastest. Thus, the use of Yb is advantageous to shorten the heating time for precipitation. Gd strongly tends to suppress an increase in strength in a solid solution state, and thus is more suitable for applications in which a workability at an ordinary temperature such as improvement of workability of deformation and bonding of the Al wiring material is prioritized.

One or more of the first group elements can be selected and selectively used according to the application and required characteristics. For example, when Er and Yb are designed to coexist, it is advantageous in order to reduce the content and increase the precipitation rate. When Er and Gd are designed to coexist, it is advantageous in order to simultaneously enhance the workability of deformation and bonding at an ordinary temperature, and the performance of maintaining and improving the strength during use in a high-temperature environment. Combinations of the first group elements are not limited to these, and Yb and Gd may be combined, or all three elements may be combined.

The Al wiring material of the present invention contains, as the first group element, one or more selected from the group consisting of Er, Yb and Gd in a total amount of 0.001 to 0.6% by mass. That is, it satisfies $0.001 \leq x1 \leq 0.6$ where x1 is the total content of the first group elements in the Al wiring material [% by mass].

From the viewpoint of obtaining the Al wiring material with the increased strength during use in a high-temperature environment and a favorable high-temperature reliability, the total content of the first group elements in the Al wiring material, i.e., x1 is 0.001% by mass or more, preferably 0.002% by mass or more, 0.003% by mass or more or 0.005% by mass or more, and more preferably 0.01% by mass or more, 0.02% by mass or more, 0.03% by mass or more, 0.05% by mass or more, 0.07% by mass or more, 0.09% by mass or more or 0.1% by mass or more. When x1 is 0.01% by mass or more, it has been confirmed that the Al wiring material having better high-temperature reliability can be achieved.

From the viewpoint of obtaining the Al wiring material with improved workability of deformation and bonding by suppressing an increase in cold strength, the upper limit of the total content of the first group elements in the Al wiring material, i.e., x1 is 0.6% by mass or less, preferably 0.55% by mass or less, and more preferably 0.5% by mass or less. When x1 is 0.5% by mass or less, it has been confirmed that the Al wiring material with a much better workability at an ordinary temperature can be achieved.

Accordingly, in a preferred embodiment, the total content of the first group elements in the Al wiring material, i.e., x1 satisfies $0.001 \leq x1 \leq 0.6$, and more preferably $0.01 \leq x1 \leq 0.5$.

- Sc, Zr (second group element) -

The Al wiring material of the present invention may further contain one or more selected from the group consisting of Sc and Zr.

When the Al wiring material contains, in addition to the first group element, one or more selected from the group consisting of Sc and Zr (also referred to as "second group element"), it is possible to achieve the Al wiring material that has more increased strength during use in a high-temperature environment and much better high-temperature reliability while suppressing an increase in cold strength to maintain the workability of, for example, deformation and bonding at an ordinary temperature. For example, for the Al wiring material in which the second group element and the first group element are added in combination, the strength in a higher temperature range can be improved. Furthermore, the high-temperature reliability of the connection part can be further improved when subjected to a thermal history in which a high temperature and a low temperature are repeated during high-power operation of an electronic device.

There will be described an example of the properties evaluated for the Al wiring material in which the second group element and the first group element are added in combination. Specific examples of the effect that such Al wiring material can achieve during use in a severe high-temperature are as follows. In a first example, even after being heated at a high temperature of, for example, 400°C, deterioration of the rupture strength of the Al wiring material can be suppressed, and rather the rupture strength can be increased. This shows the possibility that superior reliability can be achieved even at higher temperature by 50°C or more compared to a case where the first group element is added solely.

In a second example, the Al wiring material in which the second group element and the first group element are added in combination can achieve further improvement in the high-temperature reliability of the connection part with a member to be connected. In particular, it is possible to achieve a long life while maintaining a high bonding strength against the thermal shock in which the temperature rises and falls repeatedly. Herein, a power cycle test is performed as one of accelerating test methods of thermal shock. This test repeats rapid heating and cooling by turning the voltage on and off repeatedly. When the bonding strength of the connection part with a member to be connected is reduced or deteriorates due to the thermal shock, there arise problems that cracks develop in the vicinity of the connecting interface to cause peeling-off, and the like. With regard to the thermal distortion that occurs at the connection part of the Al wiring material due to rapid heating and cooling, it is possible to improve the high-temperature reliability of the connection part by suppressing the phenomena where crystal grains in the wiring material grow and are coarsened, which may be a concern in the conventional Al wiring material. Although it has been confirmed that the high-temperature reliability of the connection part can be improved even when the first group element is added solely, the addition of the second group element in combination with the first group element can provide a more remarkable improvement effect.

When the first group element and the second group element are added in combination, Al and one or two of the first group element and the second group element form an intermetallic compound as a precipitate in addition to the formation of solid solution of the elements. It is considered that the resultant precipitate can suppress the migration of the grain boundaries in the wiring material and at the connection part and the coarsening of the crystal grains in a high-temperature environment, thereby achieving the remarkable effect described above. A ternary intermetallic compound is representative, and examples thereof may include $Al_3(Er, Sc)$, $Al_3(Yb, Sc)$, $Al_3(Er, Zr)$, and $Al_3(Gd, Zr)$. A binary precipitate is also formed in part, and examples thereof may include $Al_3Er$ and $Al_3Sc$. Herein, with regard to the expression of chemical composition such as $Al_3(Er, Sc)$, it may be expressed as $Al_3 (Er_x, Sc_{1-x})$ (where x satisfies $0 < x < 1$), but in the present specification, the simple expression of $Al_3(Er, Sc)$ is used. The chemical composition of the precipitate is not limited to those described above.

With regard to the elemental distribution in the ternary precipitate, a composite structure (core-shell structure), in which the inner part (core) and the outer shell (shell) are composed of respective different elements, also effectively acts on the improvement of the high-temperature characteristics. For the Al wiring material in which the first group element and the second group element are added in combination, it has been revealed by TEM analysis of the precipitate and the like that the first group element tends to be dense in the inner part of the precipitate while the second group element tends to be dense in the outer shell. For example, the Al-Er-Sc ternary precipitate tends to form a structure in which Er is dense in the inner part and Sc is dense in the outer shell. The Al-Yb-Zr ternary precipitate tends to form a structure in which Yb is dense in the inner part and Zr is dense in the outer shell. It is considered that this is because the first group element having a high diffusion speed rapidly aggregates to form a core precipitate with Al, and the second group element precipitates around the core precipitate as a nucleus to form a shell. As a method for analyzing the chemical composition of the precipitate, a composition analysis (EDS analysis) using a transmission electron microscope (TEM) or the like can be used.

As an advantage of the core-shell structure, even in a high-temperature range in which the core part composed of the first group element and Al is coarsened, the shell part suppresses the growth of the precipitate, thereby maintaining fine precipitates. This provides a remarkable effect in which the reliability of the Al wiring material can be maintained even in a considerably higher temperature range. This is also a factor that the remarkable effect described above is achieved when the first group element and the second group element are added in combination. With regard to the formation of the precipitate with the core-shell structure, the difficulty in stable distribution in the inner part of the sample of a large member, such as a bulk, may become hindrance. However, it has been found that it is relatively easy to uniformly distribute the precipitate with the core-shell structure in the Al wiring material which is a two-dimensional wiring material. That is, an Al wiring material in which the first group element and the second group element are added in combination is advantageous for mass production as a product for enhancing high-temperature properties. A three-dimensional atom probe (3 Dimensional Atom Probe: 3DAP) method or the like can be used as a method for analyzing the structure and chemical composition of such precipitates. Furthermore, the structure can be analyzed by the concentration distribution of the elements in the precipitate.

The combined addition in which a plurality of elements such as the first group element and the second group element (and furthermore, a third group element to be described later) are simultaneously added is also economically advantageous. Specifically, it is possible to reduce the content of expensive Sc as well as to satisfy the requirements by using the second group element in a smaller amount. As a consequence, it is possible to reduce the cost for the raw materials by also reducing the amount of the first group element to be used. Furthermore, as for the heat treatment conditions for improving the high-temperature reliability, it is possible to form a precipitate in a short time at low temperature by the combined addition, and also to achieve the advantage of the improved productivity.

The Al wiring material preferably contains, as the second group element, one or more selected from the group consisting of Sc and Zr in a total amount of 0.005 to 0.6% by mass. That is, it satisfies $0.005 \leq x2 \leq 0.6$ where x2 is the total content of the second group elements in the Al wiring material [% by mass].

From the viewpoint of obtaining the Al wiring material with the further increased strength during use in a high-temperature environment and much better high-temperature reliability, the total content of the second group elements in the Al wiring material, i.e., x2 is preferably 0.005% by mass or more, and more preferably 0.006% by mass or more, 0.008% by mass or more or 0.009% by mass or more, further preferably 0.01% by mass or more, 0.02% by mass or more, 0.03% by mass or more, 0.05% by mass or more or 0.1% by mass or more. When x2 is 0.01% by mass or more, it has been confirmed that the Al wiring material having much better high-temperature reliability can be achieved.

From the viewpoint of obtaining the Al wiring material with improved workability of deformation and bonding at an ordinary temperature by suppressing an increase in cold strength, the upper limit of the total content of the second group elements in the Al wiring material, i.e., x2 is preferably 0.6% by mass or less, more preferably 0.55% by mass or less, and further preferably 0.5% by mass or less. When x2 is 0.5% by mass or less, it has been confirmed that the Al wiring material with a much better workability at an ordinary temperature can be achieved. In the Al wiring material of the present invention in which the first group element is added, the content of the second group element can be reduced, and x2 may be as low as 0.45% by mass or less, 0.4% by mass or less, 0.35% by mass or less, 0.3% by mass or less, 0.25% by mass or less, 0.2% by mass or less, 0.15% by mass or less or less than 0.15% by mass.

Accordingly, in a preferred embodiment, the total content of the second group elements in the Al wiring material, i.e., x2 satisfies $0.005 \leq x2 \leq 0.6$, and more preferably satisfies $0.01 \leq x2 \leq 0.5$.

- Si, Fe, Ni, Ce, Y, Zn (third group element) -

The Al wiring material of the present invention may further contain one or more selected from the group consisting of Si, Fe, Ni, Ce, Y and Zn.

When the Al wiring material contains, in addition to the first group element, one or more selected from the group consisting of Si, Fe, Ni, Ce, Y and Zn (also referred to as "third group element"), it is possible to improve the high-temperature reliability in the second connection which is the connection between the Al wiring material and a lead frame or an external electrode on a substrate, or it is possible to improve the bending deformability of the Al wiring material at a high temperature. By adding the third group element and the first group element in combination, compared to a case where the first group element is added solely, a higher effect in suppressing the degradation of the bonding strength even in a high-temperature environment of 200°C or more can be achieved in the second connection with the external electrode made of a material which has a higher melting point and is harder than Al.

The lead frame and the external electrode on a substrate is not particularly limited, and examples thereof may include a Cu-base alloy and an Fe-base alloy which are coated with Ni, Ag, Pd or the like. In the second connection, since the size and thickness of the external electrode are relatively large, the reliability is relatively more easily secured than the first connection on the chip side. Nevertheless, under severe use conditions, there is a problem that voids and cracks occur at the connection interface due to a high-temperature environment or a heat generation during operation where a high voltage is applied. In the future, if the Al wiring material is made thinner, the high-temperature reliability of the connection part with the external electrodes becomes problematic. This is related to difficulty in obtaining a metallic bonding at the connection interface and the delayed diffusion speed at the interface because the member to be connected is hard and has a high melting point, so deformation of the Al wiring material occurs mainly at the time of connection.

Since the amount of the third group element of Si, Fe, Ni, Ce, Y and Zn present in the solid solution state in Al is larger than the first group element, the third group element is possible to contribute to further improvement of the high-temperature reliability by affecting the solid solution strengthening or a processed/recrystallized structure. When the solid solution of the third group element and the precipitation of the first group element are combined, it is possible to expose a nascent metal surface at the connection part with the hard member to be connected, thus promoting the interdiffusion. Further, when the Al wiring material is subjected to a heat treatment, a ternary alloy precipitate composed of Al, the third group element and the first group element is formed. Thus, uniform deformation of the Al wiring material can be promoted in the connection where the ultrasonic wave is applied. It is considered that the synergistic action of such solid solution and precipitation and the formation of the ternary intermetallic compound can improve the high-temperature reliability at the connection part with the external electrode. Examples of the chemical composition of the ternary intermetallic compound may include, but are not limited to, $Al_3(Er, Si)$, $Al_3(Yb, Si)$, $Al_3(Er, Ni)$, and $Al_3(Gd, Si)$.

The Al wiring material of the present invention preferably contains, as the third group element, one or more selected from the group consisting of Si, Fe, Ni, Ce, Y and Zn in a total amount of 0.001 to 1% by mass. That is, it satisfies $0.001 \leq x2 \leq 1$ where x3 is the total content of the third group elements in the Al wiring material [% by mass].

From the viewpoint of obtaining the Al wiring material with a favorable high-temperature reliability of the second connection part, the total content of the third group elements in the Al wiring material, i.e., x3 is preferably 0.001% by mass or more, and more preferably 0.002% by mass or more, further preferably 0.003% by mass or more, 0.005% by mass or more, 0.006% by mass or more, 0.008% by mass or more, 0.009% by mass or more or 0.01% by mass or more. When x3 is 0.003% by mass or more, it has been confirmed that the Al wiring material having much better high-temperature reliability of the second connection part can be achieved.

From the viewpoint of obtaining the Al wiring material with improved workability of deformation and bonding at an ordinary temperature by suppressing an increase in the cold strength, the upper limit of the total content of the third group elements in the Al wiring material, i.e., x3 is preferably 1% by mass or less, more preferably 0.9% by mass or less, and further preferably 0.8% by mass or less. When x3 is 0.8% by mass or less, it has been confirmed that the Al wiring material with a much better workability at an ordinary temperature can be achieved.

Accordingly, in a preferred embodiment, the total content of the third group elements in the Al wiring material, i.e., x3 satisfies $0.001 \leq x3 \leq 1$ and more preferably satisfies $0.003 \leq x3 \leq 0.8$.

The balance, the remaining part, of the Al wiring material according to the present invention contains Al.

As an aluminum raw material for manufacturing the Al wiring material, an industrially pure Al having a purity of 4N (Al: 99.99% by mass or more) can be used. More preferably, aluminum having a purity equal to or higher than 5N (Al: 99.999% by mass or more) is used. In a range of not inhibiting the effect of the present invention, the balance of the Al wiring material according to the present invention may contain an element other than Al. The content of Al in the balance of the Al wiring material according to the present invention is not limited so long as the content does not inhibit the effect of the present invention, and is preferably 98% by mass or more, 98.5% by mass or more, 99% by mass or more, 99.5% by mass or more, 99.6% by mass or more, 99.7% by mass or more, 99.8% by mass or more, or 99.9% by mass or more. According to a preferred embodiment, the balance of the Al wiring material of the present invention consists of Al and inevitable impurities.

The contents of the first group element, the second group element, the third group element, and the like in the Al wiring material can be measured by using the method in [Measurement of element content] described later.

The Al wiring material of the present invention may have a coating that contains a metal other than Al as a main component on an outer periphery of the Al wiring material, or does not necessarily have the coating. In a preferred embodiment, the Al wiring material of the present invention does not have a coating that contains a metal other than Al as a main component on the outer periphery of the Al wiring material. Herein, the "coating that contains a metal other than Al as a main component" means the coating in which the content of the metal other than Al is 50% by mass or more.

The Al wiring material of the present invention can suppress an increase in the cold strength and enhance the workability during installation and connection to the device and the productivity. In addition, by performing a low-temperature or short-time treatment for the heat treatment during the production of the wiring material or the additional heat treatment after connection or without requiring the heat treatment, the strength during use in a high-temperature environment can be maintained and improved, and a favorable high-temperature reliability can be exhibited. Therefore, the Al wiring material of the present invention can be used in wide applications that require both of the workability at an ordinary temperature and the high-temperature reliability at the time of connection to a member to be connected. For example, the Al wiring material can be suitably used for connection to a member to be connected in industrial devices such as a conveying device and a robot (Al wiring material for industrial devices). The Al wiring material can be suitably used for connection to a member to be connected in various semiconductor devices including a power semiconductor device (Al wiring material for semiconductor devices).

The Al wiring material of the present invention may have an arbitrary size depending on a specific aspect of use. In a case where the Al wiring material of the present invention is an Al wire used for industrial devices such as a conveying device and a robot, the diameter of the Al wire is not particularly limited and may be 500 $\mu$m to 10 mm, for example. The Al wiring material may be a stranded wire formed from a plurality of Al wires. In a case where the Al wiring material is an Al strip, the dimensions (w $\times$ t) of a rectangular or substantially rectangular cross section thereof are not particularly limited, and w may be 500 $\mu$m to 10 mm, and t may be 50 $\mu$m to 2 mm, for example. In a case where the Al wiring material of the present invention is an Al bonding wire used for various semiconductor devices including a power semiconductor device, the diameter of the Al bonding wire is not particularly limited and may be 50 to 600 $\mu$m, for example. In a case where the Al wiring material is an Al bonding ribbon, the dimensions (w $\times$ t) of a rectangular or substantially rectangular cross section thereof are not particularly limited, and w may be 100 to 3,000 $\mu$m, and t may be 50 to 600 $\mu$m, for example.

A manufacturing method for the Al wiring material of the present invention is not particularly limited. For example, the Al wiring material of the present invention may be manufactured by using a known processing method such as extrusion processing, swaging processing, wire-drawing processing, and rolling processing, for example. When the wire diameter is small to some extent, it is preferable that wire-drawing processing with diamond dies is performed. With regard to the cold working in which the wire-drawing is performed at an ordinary temperature, a production device and the like therefor have a relatively simple configuration and a workability thereof is excellent. When the resistance during wire-drawing is decreased so as to increase the productivity, there may be used the hot working in which the wire-drawing is performed while heating.

After weighing pure metals of Al and additive elements as starting materials so that the content of each additive element falls within a specific range, these materials are mixed and then molten and solidified to form an ingot. Alternatively, as the raw material for each additive element, a mother alloy containing the additive element in high concentration may be used. In the process of melting for producing the ingot, a batch process or a continuous casting process can be used. The continuous casting process has an excellent productivity, and the batch process is easy to change a cooling temperature condition for solidification. The Al wiring material can be formed by processing the ingot to have final dimensions.

In order to make each additive element into a solid solution so as to be uniformly distributed, it is preferable to perform a solution heat treatment in a state of the ingot, in the middle of processing or after the processing end. In the solution heat treatment, the additive elements are dissolved in Al at a high temperature at which solid solubility is high. Then, the resultant is cooled to an ordinary temperature at increased cooling rate by water cooling, air cooling, or the like in order to suppress the precipitation of the dissolved elements. The solution heat treatment may be performed, for example, by heating at a temperature range of 550 to 640°C for 1 hour to 20 hours, followed by cooling with water cooling, air cooling, or the like. When the cooling rate of the ingot is high in a batch process, the time for the solution heat treatment can be shortened because most of the additive elements are dissolved. Alternatively, by performing a heat treatment at a high temperature at which the solubility is high, a precipitate that has been generated during solidification of the ingot may be redissolved so as to achieve a state in which the additive elements are uniformly distributed. Therefore, the solution heat treatment can be substituted by increasing the cooling rate during solidification. For example, in the continuous casting process, the solidification rate can be increased as compared to the solidification in the batch solution process, and thus the additive elements are relatively easily dissolved in Al. Therefore, when using the continuous casting process, the solution heat treatment may not be performed.

In order to promote the precipitation in an Al alloy that has been subjected to the solution heat treatment, it is preferable to perform a precipitation heat treatment. The precipitation heat treatment can be performed immediately after the solution heat treatment, in the middle of subsequent processing or after the processing end. When subjecting to the precipitation heat treatment in a state of large wire diameter by a batch process, the precipitation heat treatment may be performed, for example, by heating at a temperature range of 200 to 450°C for 10 minutes to 5 hours. Specific examples of the conditions may include a low-temperature condition of 250°C for 3 hours and a high-temperature condition of 350°C for 30 minutes. Alternatively, when subjecting to the precipitation heat treatment in a state of processed small wire diameter by a continuous manner, the precipitation heat treatment may be performed, for example, by heating the wire at a temperature range of 400 to 600°C for 1 second to 5 minutes while the wire is continuously moved in a furnace. Specifically, the condition may be 400°C for 5 seconds for suppressing the development of precipitation, and may be 500°C for 1 minute for promoting the formation of the precipitate, for example. Referring to the above heat treatment conditions, the temperature and time may be determined. In order to optimize the conditions more precisely, the temperature, the time, and the like can be easily optimized by an isothermal heat treatment or an isochronal heat treatment referring to the above heat treatment conditions. For example, when Al wiring materials subjected to an isothermal heat treatment under several time conditions are prototyped and mechanical properties thereof are measured, desired properties can be easily reproduced.

In the middle of processing the Al wiring material or in the final diameter of the Al wiring material, the Al wiring material may be subjected to a thermal refining heat treatment. By performing the thermal refining heat treatment, the working strain is removed, and a recrystallized structure is formed. By combination of the thermal refining heat treatment with the precipitation heat treatment described above, the precipitate can be grown. In this thermal refining heat treatment, it is preferable that the heat treatment is continuously performed while the Al wiring material is continuously swept in a heating furnace. Examples of this heat treatment condition may include heating at a temperature range of 400 to 600°C for a short time of 0.1 seconds to 3 minutes. By performing the thermal refining heat treatment, precipitation can be proceeded. Therefore, the thermal refining heat treatment can simultaneously serve also as the precipitation heat treatment depending on a necessary degree of precipitation.

Regarding connection between the Al wiring material of the present invention and the member to be connected in a semiconductor device, both of the first connection with an electrode on a semiconductor chip and the second connection with a lead frame or an external electrode on a substrate are performed by wedge bonding. After connection with the member to be connected, the semiconductor device including the Al wiring material is preferably subjected to a post-bonding heat treatment. By performing the post-bonding heat treatment, a precipitate which is an intermetallic compound is formed in the Al wiring material, and thus, the strength can be further increased by precipitation strengthening. In the Al wiring material of the present invention, the chemical composition and type of the formed precipitate are as described above.

A condition for the post-bonding heat treatment is not particularly limited as long as the intermetallic compound can be formed. For example, the post-bonding heat treatment is preferably performed at a temperature range of 200 to 400°C for 10 to 60 minutes. An atmosphere during the post-bonding heat treatment may be the atmospheric air, or may be an inert atmosphere such as nitrogen and argon for suppression of oxidation of members.

The present invention also provides a manufacturing method for the semiconductor device. In a preferred embodiment, the manufacturing method for the semiconductor device of the present invention includes:

(A) a step of connecting the electrode on the semiconductor chip to the lead frame or the electrode on the substrate via the Al wiring material of the present invention; and
(B) a step of performing the post-bonding heat treatment after the connection via the Al wiring material.

For the semiconductor chip, the lead frame, or the substrate used at the step (A), known components that may be used for constituting the semiconductor device may be used as described later. Details and preferred aspects of the Al wiring material of the present invention used at the step (A) are as described above. At the step (A), both of the first connection with the electrode on the semiconductor chip and the second connection with the lead frame or the electrode on the substrate may be performed by wedge bonding. In the step (B), the fine precipitate phase of the intermetallic compound described above can be formed in the Al wiring material.

[Semiconductor device]

The semiconductor device can be manufactured by connecting the electrode on the semiconductor chip to the lead frame or the electrode on the substrate by using the Al wiring material of the present invention.

The semiconductor device of the present invention includes the Al wiring material of the present invention. The Al wiring material of the present invention can suppress an increase in cold strength and enhance the workability during installation and connection to the device and the productivity. In addition, by performing a low-temperature or short-time treatment for the heat treatment during the production of the wiring material or the additional heat treatment after the connection or without requiring the heat treatment, the strength during use in a high-temperature environment can be maintained and improved, and a favorable high-temperature reliability can be exhibited. Therefore, the semiconductor device including the Al wiring material can achieve a favorable operation reliability for a long time even in a high-temperature operation environment, as well as can decrease a thermal influence on a member to be connected. Accordingly, the semiconductor device including the Al wiring material of the present invention comprehensively satisfy many required performances.

In one embodiment, the semiconductor device of the present invention includes the circuit board, the semiconductor chip, and the Al wiring material for bringing the circuit board and the semiconductor chip into conduction with each other, and is characterized in that the Al wiring material is the Al wiring material of the present invention. It should be noted that the "Al wiring material of the present invention" related to the semiconductor device of the present invention is characterized by containing the first group element, and as necessary, the second group element and the third group element in the preferred concentration ranges described above.

In the semiconductor device of the present invention, the fine phase of the precipitate separated from Al (for example, a precipitate of the above-described binary or ternary intermetallic compound) can be maintained as it is even when the semiconductor device is operated for a long time in a high-temperature environment.

In the semiconductor device of the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in JP-A-2020-150116 and JP-A-2002-246542, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

**Examples**

Hereinafter, the present invention will be described in detail with reference to Examples. However, the present invention is not limited to the following Examples.

(Sample)

A method for producing a sample will be described. Al having a purity of 5 N (99.999% by mass or more), and Er, Yb, Gd, Sc, Zr, Si, Fe, Ni, Ce, Y and Zn having a purity of 99.9% by mass or more were molten as raw materials, and an Al ingot having each composition indicated in Tables 1 and 2 was prepared. Subsequently, the ingot was subjected to a solution heat treatment at a range of 550 to 640°C for 5 hours, and quenched (water-cooled). The ingot was then subjected to an extrusion process, a swaging process, followed by a wire-drawing process. Some of the samples were subjected to a precipitation heat treatment at a range of 350 to 600°C for 1 to 60 minutes at a stage where the wire diameter was 2 mm. Thereafter, a wire-drawing process using dies was performed to achieve a final wire diameter of 300 $\mu$m. After the wire-drawing processing ended, thermal refining heat treatment was performed in a heat treatment time of 2 seconds, and thus obtaining the Al wiring material.

[Measurement of element content]

The content of additive elements in the Al wiring material was measured by using ICP-OES ("PS3520UVDDII" manufactured by Hitachi High-Tech Corporation) or ICP-MS ("Agilent 7700x ICP-MS" manufactured by Agilent Technologies, Inc.) as an analysis device.

[Mechanical properties of wire]

- Change in strength after heating -

Before and after a heat treatment, a tensile test was performed, and a change in strength after heating a wire was evaluated as a change in breaking strength of the wire. For measurement of the breaking strength, the tensile test was performed with a tensile tester manufactured by Instron under conditions of a distance between gauge points of 100 mm, a tensile speed of 10 mm/min, and a load cell rating load of 1 kN. An average value obtained in five measurements was used. The heat treatment of the wire was performed in a nitrogen atmosphere at 350°C for 4 hours or at 400°C for 1 hour. The change in strength after heating was evaluated by a ratio F2/F1 where the wire strength before the heat treatment was F1 and the wire strength after the heat treatment was F2. In the "Change in strength after heating" column of Tables 1 and 2, a case in which the ratio F2/F1 was 1.2 or more was marked with a symbol of "double circle" since an improvement in the high-temperature reliability of the wire was significant, a case in which the ratio F2/F1 was 1.0 or more and less than 1.2 was marked with a symbol of "circle" since the strength was favorable in a general high-temperature environment, a case in which the ratio F2/F1 was 0.7 or more and less than 1.0 was marked with a symbol of "triangle" since the strength had no problem for normal use, but it was necessary to pay attention for use in a high-temperature environment, and a case in which the ratio F2/F1 was less than 0.7 was marked with a symbol of "cross" since the high-temperature reliability was inferior.

- Measurement of hardness -

The Vickers hardness Hv of the longitudinal axis part of the Al wiring material was measured by using a micro Vickers hardness tester. The measurement target area was set to a cross section (L cross section) parallel with the longitudinal direction including the longitudinal axis of the Al wiring material, and hardness at the longitudinal axis part (that is, the center position of the Al wiring material) was measured. An average of measurement values at five points was employed as the Vickers hardness of the sample. In the "Hardness Hv" column of Tables 1 and 2, a case in which the Vickers hardness Hv was within the range of 20 or more and less than 35 was marked with a symbol of "circle" since the Al wiring material was soft, a case in which it was within the range of 35 or more and less than 45 was marked with a symbol of "triangle", and a case in which it was within the range of 45 or more was marked with a symbol of "cross" since the Al wiring material was hard and had a concern of inferior deformability.

<Connection>

In the semiconductor device, the electrode on the semiconductor chip was an Al-Cu pad (thickness: 2 $\mu$m), and an Ni-coated Cu lead frame was used for an external terminal. A first connection part between the electrode on the semiconductor chip and the Al wiring material, and a second connection part between the external terminal and the Al wiring material were both wedge-bonded. In some Examples and Comparative Examples, a post-bonding heat treatment (aging heat treatment) was performed at 300°C for 30 minutes after the connection.

<Evaluation of chip damage>

A chip damage in the semiconductor device was evaluated by dissolving metal on a pad surface by acid, and observing a part under the pad by a microscope (the number of evaluations N = 50). In the "chip damage" column of Tables 1 and 2, a case in which a crack, traces of bonding and the like were not found was determined to be favorable to be marked with a symbol of "circle", a case in which there was no crack but traces of bonding were found at some spots (three spots or less of the number of evaluations 50) was marked with a symbol of "triangle", and other cases were marked with a symbol of "cross".

<Evaluation of high-temperature reliability>

- First connection part -

The high-temperature reliability with respect to the first connection part was evaluated by a power cycle test. In the power cycle test, heating and cooling were alternately and repeatedly performed for the semiconductor device in which the Al wiring material was connected. In the heating, two types of conditions including a middle-temperature condition and a high-temperature condition were used. For the middle-temperature condition, heating was performed for 2 seconds until the maximum temperature of the connection part of the Al wiring material in the semiconductor device reached about 120°C, and cooling was performed for 20 seconds until the temperature of the connection part reached 30°C thereafter. This heating-cooling cycle was repeated 100,000 times. For the high-temperature condition, heating was performed for 2 seconds until the maximum temperature of the connection part of the Al wiring material in the semiconductor device reached about 140°C, and cooling was performed for 25 seconds until the temperature of the connection part reached 30°C thereafter. This heating-cooling cycle was repeated 100,000 times.

- Second connection part -

The high-temperature reliability with respect to the second connection part was evaluated by a temperature cycle test (hereinafter referred to as TCT). TCT was a test in which the semiconductor device in which the Al wiring material was connected was placed in a furnace of a temperature cycle tester and switching between a high temperature and a low temperature was continuously repeated. The high temperature was set to 125°C, and the low temperature was set to -40°C. The cycle of the high temperature and the low temperature was repeated 1,000 times.
The high-temperature reliability of the connection part was evaluated by measuring the bond shear force of the first connection part after the power cycle test and the bond shear force of the second connection part after the temperature cycle test. The high-temperature reliability was evaluated by a ratio S2/S1 where the initial shear force of the connection part was S1 and the shear force after the power cycle test or the temperature cycle test was S2. In the "High-temperature reliability" column of Tables 1 and 2, a case in which the ratio S2/S1 was 0.9 or more was marked with a symbol of "double circle" since the reliability was excellent, a case in which the ratio S2/S1 was 0.8 or more and less than 0.9 was marked with a symbol of "circle" since the reliability was favorable, a case in which the ratio S2/S1 was 0.6 or more and less than 0.8 was marked with a symbol of "triangle" since the reliability had no problem for normal use, but it was necessary to pay attention, and a case in which the ratio S2/S1 was less than 0.6 was marked with a symbol of "cross" since the high-temperature reliability was inferior.
The production conditions of the Al wiring materials and the evaluation results are shown in Tables 1 and 2.

[Table 1]

(Table 1)

| Working Example No. | First group element (% by mass) | | | Second group element (% by mass) | | | Third group element (% by mass) | | | | | Solution heat treatment (°C) | Precipitation heat treatment (°C) | Change in strength after heating 350°C | Change in strength after heating 400°C | Hardness Hv | Chip damage | First connection part Middle temp. | First connection part High temp. | Second connection part | Post-bonding heat treatment |
|---|---|---|---|---|---|---|---|---|---|---|---|---|---|---|---|---|---|---|---|---|---|
| | Er | Yb | Gd | Sc | Zr | Si | Fe | Ni | Ce | Y | Zn | | | | | | | | | | |
| 1 | 0.002 | | | | | | | | | | | 620 | — | ○ | △ | ○ | ○ | ○ | △ | △ | No |
| 2 | 0.01 | | | 0.005 | 0.005 | 0.006 | | | | | | 580 | 350 | ◎ | ◎ | ○ | ○ | ◎ | ◎ | ◎ | Yes |
| 3 | 0.02 | | | 0.1 | | | 0.1 | | | | | 620 | — | ◎ | ◎ | ○ | ○ | ◎ | ◎ | ◎ | Yes |
| 4 | 0.08 | | | | | | | 0.006 | | | | 620 | 520 | ◎ | ○ | ○ | ○ | ◎ | ○ | ◎ | Yes |
| 5 | 0.1 | | | | | | | | 0.05 | | | 620 | 300 | ◎ | ○ | ○ | ○ | ◎ | ○ | ◎ | Yes |
| 6 | 0.15 | | | 0.05 | 0.05 | 0.1 | 0.1 | | | | | 620 | 450 | ◎ | ◎ | ○ | ○ | ◎ | ◎ | ◎ | No |
| 7 | 0.2 | | | | | | | | | 0.1 | 0.2 | 600 | 350 | ◎ | ◎ | ○ | ○ | ◎ | ◎ | ◎ | Yes |
| 8 | 0.2 | | | 0.2 | | | | | | | | 620 | — | ◎ | ◎ | ○ | ○ | ◎ | ◎ | ◎ | No |
| 9 | 0.2 | | | 0.1 | 0.1 | | | 0.003 | | | | 620 | 600 | ◎ | ◎ | ○ | ○ | ◎ | ◎ | ◎ | No |
| 10 | 0.5 | | | | 0.2 | | 0.2 | | | | | 580 | 500 | ○ | ○ | ○ | ○ | ○ | △ | △ | No |
| 11 | | 0.05 | | | | | | | | | | 580 | — | ○ | ○ | ○ | ○ | ○ | ○ | ◎ | Yes |
| 12 | | 0.001 | | | 0.005 | 0.005 | | | | | | 580 | 380 | ◎ | ◎ | ○ | ○ | ◎ | ○ | △ | No |
| 13 | | 0.01 | | 0.004 | 0.01 | | | | | | | 620 | 450 | ○ | △ | ○ | ○ | ○ | △ | △ | Yes |
| 14 | | 0.02 | | | | 0.001 | | | | | | 620 | 500 | ◎ | ○ | ○ | ○ | ◎ | ○ | ◎ | Yes |
| 15 | | 0.08 | | 0.005 | | | 0.1 | | | | | 600 | 600 | ◎ | ◎ | ○ | ○ | ◎ | ◎ | ○ | Yes |
| 16 | | 0.1 | | 0.2 | 0.2 | 0.002 | | | | | | 620 | — | ◎ | ◎ | ○ | ○ | ◎ | ◎ | ◎ | Yes |
| 17 | | 0.2 | | 0.1 | 0.1 | | | 0.002 | | | | 610 | 400 | ◎ | ◎ | ○ | ○ | ◎ | ◎ | △ | Yes |
| 18 | | 0.4 | | | | | | | | | | 620 | 400 | ○ | ○ | ○ | ○ | ○ | △ | ◎ | Yes |
| 19 | | 0.1 | | | | | | 0.007 | 0.1 | 0.1 | | 580 | — | ◎ | ◎ | ○ | ○ | ◎ | ◎ | ◎ | No |
| 20 | | 0.2 | | 0.2 | 0.2 | | 0.2 | | | | | 600 | 350 | ◎ | ◎ | ○ | ○ | ◎ | ◎ | ◎ | Yes |
| 21 | | 0.3 | | | 0.05 | | | | | 0.1 | 0.5 | 620 | 300 | ○ | ○ | ○ | ○ | ○ | △ | △ | No |
| 22 | | | 0.1 | | | | | | | | | 600 | — | ○ | △ | ○ | ○ | ○ | △ | △ | Yes |
| 23 | | | 0.008 | | 0.004 | | 0.005 | | | | | 550 | 450 | ◎ | ◎ | ○ | △ | ◎ | ◎ | ◎ | Yes |
| 24 | | | 0.2 | 0.2 | | 0.4 | 0.4 | | | | | 580 | 400 | ◎ | ◎ | ○ | ○ | ◎ | ○ | △ | Yes |
| 25 | | | 0.2 | | 0.6 | | | | | | | — | 500 | ◎ | ◎ | ○ | ○ | ◎ | ◎ | ◎ | Yes |
| 26 | | | 0.1 | 0.1 | | 0.1 | 0.1 | | 0.08 | | | — | 300 | ◎ | ◎ | ○ | ○ | ◎ | ◎ | ◎ | Yes |
| 27 | | | 0.4 | 0.2 | 0.05 | | | | | 0.1 | 0.5 | 550 | 400 | ◎ | ◎ | ○ | ○ | ◎ | ◎ | ◎ | Yes |
| 28 | | | 0.6 | | | 0.05 | | | | | | 640 | 400 | ◎ | ○ | ○ | ○ | ◎ | △ | ◎ | No |

(Table 2)

| | | Additive elements in Al wiring material | | | | | | | | | | | Heat treatment condition | | Mechanical properties | | | Chip damage | High-temperature reliability | | | Post-bonding heat treatment |
|---|---|---|---|---|---|---|---|---|---|---|---|---|---|---|---|---|---|---|---|---|---|---|
| | | First group element (% by mass) | | | Second group element (% by mass) | | Third group element (% by mass) | | | | | | Solution heat treatment | Precipitation heat treatment | Change in strength after heating | | Hardness | | First connection part | | Second connection part | |
| | | Er | Yb | Gd | Sc | Zr | Si | Fe | Ni | Ce | Y | Zn | (°C) | (°C) | 350°C | 400°C | Hv | | Middle temp. | High temp. | | |
| Working Example | 29 | 0.002 | 0.001 | | 0.01 | 0.02 | 0.002 | | | | | | 620 | 400 | O | O | O | O | O | O | O | No |
| | 30 | 0.01 | 0.01 | | | | | 0.005 | | | | | 620 | 450 | ◎ | O | O | O | ◎ | O | ◎ | Yes |
| | 31 | 0.03 | 0.02 | | 0.03 | 0.01 | 0.005 | | | | | | 640 | 400 | ◎ | ◎ | O | O | ◎ | ◎ | ◎ | Yes |
| | 32 | | 0.005 | 0.01 | | | 0.01 | | | | | | 620 | 450 | ◎ | ◎ | O | O | ◎ | ◎ | ◎ | Yes |
| | 33 | 0.02 | 0.005 | | 0.1 | 0.1 | | | | | | | 620 | — | ◎ | ◎ | O | O | ◎ | ◎ | △ | Yes |
| | 34 | 0.2 | 0.2 | | 0.2 | | 0.4 | 0.4 | 0.2 | | | | 620 | 400 | ◎ | ◎ | △ | △ | ◎ | ◎ | ◎ | Yes |
| | 35 | | 0.2 | 0.2 | 0.4 | 0.3 | | 0.1 | | | | | 600 | 400 | ◎ | O | O | △ | ◎ | O | ◎ | No |
| | 36 | | 0.1 | 0.3 | | 0.007 | | | 0.04 | | | | 620 | 400 | ◎ | O | O | O | ◎ | O | ◎ | Yes |
| | 37 | 0.3 | | 0.3 | 0.3 | | 0.5 | 0.1 | | | | | 640 | 400 | O | ◎ | O | O | O | ◎ | ◎ | Yes |
| | 38 | 0.2 | 0.1 | 0.1 | 0.2 | 0.2 | | | | | | | 620 | 400 | ◎ | ◎ | O | O | ◎ | ◎ | △ | Yes |
| | 39 | 0.1 | 0.2 | | 0.1 | | 0.2 | 0.1 | | 0.1 | 0.15 | | 630 | 300 | ◎ | ◎ | O | O | ◎ | ◎ | ◎ | No |
| | 40 | | 0.2 | 0.1 | 0.15 | 0.08 | 0.05 | | | | 0.1 | 0.3 | 620 | 350 | ◎ | ◎ | O | O | ◎ | ◎ | ◎ | Yes |
| Comparative Example | 1 | 0.0005 | | | | | | | | | | | 620 | 300 | × | × | O | O | × | × | × | Yes |
| | 2 | | 0.0005 | | | | | | | | | | 620 | 400 | × | × | O | O | × | × | × | Yes |
| | 3 | | | 0.0008 | | | | | | | | | 620 | 400 | × | × | O | O | × | × | × | Yes |
| | 4 | 0.7 | | | | | | | | | | | 620 | 400 | ◎ | O | × | × | O | × | O | Yes |
| | 5 | 0.3 | 0.3 | 0.2 | | | | | | | | | 620 | 400 | ◎ | O | × | × | O | × | O | Yes |
| | 6 | | | | 0.2 | | | | | | | | 620 | 400 | × | × | △ | △ | △ | × | × | No |
| | 7 | | | | | 0.2 | | 0.1 | | | | | 620 | 400 | × | × | △ | △ | △ | × | △ | Yes |
| | 8 | | | | | | 0.1 | 0.2 | | | | | 620 | 400 | × | × | O | △ | × | × | △ | Yes |

For the Al wiring materials in Examples 1 to 40, the total content x1 of Er, Yb and Gd was within the range of the present invention, and the results of the change in strength after heating at 350°C, the chip damage, the hardness, and the high-temperature reliability of the first connection part under the middle-temperature condition were favorable regardless of the presence or absence of a heat treatment during production of the wiring materials and after connection as well as the temperature and time thereof.

For the Al wiring materials in Examples 2, 3, 6 to 10, 12, 13, 15 to 18, 20, 21, 24 to 27, 29, 31, and 33 to 40, the contents of Sc and Zr were also within the preferred ranges of the present invention, the results of the change in strength after heating at 400°C were favorable as marked with a symbol of "circle" or "double circle", and the results of the high-temperature reliability of the first connection part under the middle-temperature condition and the high-temperature condition were favorable as marked with a symbol of "circle" or "double circle".

For the Al wiring materials in Examples 2 to 10, 12, 14 to 17, 19 to 21, 23, 24, 26 to 32, 34 to 37, 39, and 40, the contents of Si, Fe, Ni, Ce, Y and Zn were also within the preferred ranges of the present invention, and the results of the high-temperature reliability of the second connection part were also favorable.

For the Al wiring materials in Comparative Examples 1 to 3 and 6 to 8, the contents of Er, Yb and Gd were out of the lower limit of the range of the present invention, and the results of the change in strength after heating at 350°C were inferior as marked with a symbol of "cross".

For the Al wiring materials in Comparative Examples 4 and 5, the contents of Er, Yb and Gd were out of the upper limit of the range of the present invention, and the results of the chip damage and the hardness were inferior as marked with a symbol of "cross".

**Claims**

1. An Al wiring material containing one or more selected from the group consisting of Er, Yb and Gd so as to satisfy

$$0.001 \leq x1 \leq 0.6$$

where x1 is a total content thereof [% by mass],
with the balance comprising Al.

2. The Al wiring material according to claim 1, further containing one or more selected from the group consisting of Sc and Zr so as to satisfy

$$0.005 \leq x2 \leq 0.6$$

where x2 is a total content thereof [% by mass].

3. The Al wiring material according to claim 1 or 2, further containing one or more selected from the group consisting of Si, Fe, Ni, Ce, Y and Zn so as to satisfy

$$0.001 \leq x3 \leq 1$$

where x3 is a total content thereof [% by mass].

4. The Al wiring material according to any one of claims 1 to 3, wherein the Al wiring material is a bonding wire.

5. A semiconductor device comprising the Al wiring material according to any one of claims 1 to 4.

## INTERNATIONAL SEARCH REPORT

| International application No. |
| --- |
| **PCT/JP2021/030993** |

### A. CLASSIFICATION OF SUBJECT MATTER

*H01L 21/60*(2006.01)i
FI:   H01L21/60 301F

According to International Patent Classification (IPC) or to both national classification and IPC

### B. FIELDS SEARCHED

Minimum documentation searched (classification system followed by classification symbols)

H01L21/00; C22C21/00; C22F1/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2013-89763 A (FUJI ELECTRIC CO., LTD.) 13 May 2013 (2013-05-13) paragraphs [0019], [0022], [0023] | 1, 4-5 |
| Y | paragraphs [0019], [0022], [0023] | 2-3 |
| X | JP 61-179841 A (FURUKAWA ELECTRIC CO., LTD.) 12 August 1986 (1986-08-12) page 3, upper left column, lines 2-18, upper right column, lines 16-20, lower left column, lines 1-13 | 1, 3-5 |
| Y | page 3, upper left column, lines 2-18, upper right column, lines 16-20, lower left column, lines 1-13 | 2-3 |
| Y | JP 2020-59882 A (NIPPON MICROMETAL CORP.) 16 April 2020 (2020-04-16) paragraphs [0014], [0015] | 2-3 |
| Y | JP 4-39944 A (FURUKAWA SPECIAL METAL COATED CO., LTD.) 10 February 1992 (1992-02-10) page 2, lower left column, lines 1-17 | 3 |
| Y | JP 62-130254 A (SUMITOMO ELECTRIC INDUSTRIES, LTD.) 12 June 1987 (1987-06-12) page 4, left column, lines 4-13 | 2-3 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 October 2021** | **02 November 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2021/030993**

| Patent document cited in search report | | | Publication date (day/month/year) | Patent family member(s) | Publication date (day/month/year) |
|---|---|---|---|---|---|
| JP | 2013-89763 | A | 13 May 2013 | (Family: none) | |
| JP | 61-179841 | A | 12 August 1986 | (Family: none) | |
| JP | 2020-59882 | A | 16 April 2020 | (Family: none) | |
| JP | 4-39944 | A | 10 February 1992 | (Family: none) | |
| JP | 62-130254 | A | 12 June 1987 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002314038 A
- JP 2016511529 A
- JP 2014047417 A
- JP 2016152316 A
- JP 2014129578 A
- JP 2020150116 A
- JP 2002246542 A